Europäisches Patentamt

European Patent Office

Office européen des brevets

(19)

(11) Publication number: **0 235 570**
**B1**

(12) # EUROPEAN PATENT SPECIFICATION

(45) Date of publication of the patent specification:
**29.11.89**

(21) Application number: **87101145.8**

(22) Date of filing: **28.01.87**

(51) Int. Cl.⁴: **C30B 25/12**

(54) Susceptor.

(30) Priority: **30.01.86 JP 18818/86**

(43) Date of publication of application:
**09.09.87 Bulletin 87/37**

(45) Publication of the grant of the patent:
**29.11.89 Bulletin 89/48**

(84) Designated Contracting States:
**DE FR GB IT NL**

(56) References cited:
**DE-A- 3 026 030**
**GB-A- 1 112 016**

(73) Proprietor: **TOSHIBA CERAMICS CO., LTD.,**
**26-2, 1-chome, Nishi-shinjuku, Shinjuku-ku Tokyo(JP)**

(72) Inventor: **Sasaki, Yasumi Oguni Plant Toshiba Ceram.**
**Co. Ltd., 378 Oguni-machi, Ooaza Oguni-machi,**
**Nishiokitama-gun Yamagata-ken(JP)**
Inventor: **Nozawa, Tatsuo Oguni Plant Toshiba Ceram.**
**Co. Ltd., 378 Oguni-machi, Ooaza Oguni-machi,**
**Nishiokitama-gun Yamagata-ken(JP)**
Inventor: **Kato, Shigeo Oguni Plant Toshiba Ceramics**
**Co. Ltd., 378 Oguni-machi, Ooaza Oguni-machi,**
**Nishiokitama-gun Yamagata-ken(JP)**
Inventor: **Kon, Tomio Oguni Plant Toshiba Ceramics Co.**
**Ltd., 378 Oguni-machi, Ooaza Oguni-machi,**
**Nishiokitama-gun Yamagata-ken(JP)**

(74) Representative: **Patentanwälte Ruff und Beier,**
**Neckarstrasse 50, D-7000 Stuttgart 1(DE)**

## Description

BACKGROUND OF THE INVENTION

This invention relates to an improved susceptor for use in epitaxial vapor growth in the production of semiconductor devices, or vapor phase growth for forming various types of insulation coatings, etc.

Conventional apparatus for forming epitaxial coatings on semiconductor wafers, include lateral type furnaces, barrel type furnaces and vertical type furnaces. These conventional furnaces employ high frequency heating means or lamps. High frequency heating type epitaxial devices have proven to be particularly useful since such devices can be designed in a simple configuration and the inside of the reaction furnace can easily be kept clean. While the consumption of electric power increases as the size of the semiconductor product becomes larger, an energy savings can be achieved by using solid state oscillators having high conversion efficiency instead of oscillation tubes and by using lower frequencies, which are suitable for larger size furnaces and which give high operation safety.

For an induction type heater, a susceptor made of carbon and having a dense SiC coating on its surface is used. However, as the size of the susceptor becomes larger, even if the frequency is lowered to increase the penetrating depth of electric current, the outer surface of the susceptor opposed to the induction coils will be locally heated due to the surface skin effect of eddy current and the interference with the magnetic field. That localized heating results in cracks in the SiC coating due to the difference in thermal expansion and allows impurities contained in carbon to contaminate the semiconductor wafers. Futher, although the generation of cracks can be suppressed by increasing the distance between the induction coils and the susceptor, the energy efficiency is thereby reduced so much that the desired temperature cannot be attained. Further, these problems are acute because the specific electric resistance of the carbon substrate in the conventional susceptor is about 1000 μΩcm.

SUMMARY OF THE INVENTION

In view of the foregoing problems, an object of the invention is to provide a susceptor for high frequency heating with higher heating efficiency and less susceptability to the generation of cracks.

Other objects and further scope of applicability of the present invention will become apparent from the detailed description to follow.

In accordance with the present invention, the specific electric resistance of the carbon substrate used for the susceptor is from 1600 to 5500 μΩcm. A dense, nonporous SiC coating having a thickness of at least 10 μm is formed thereon. Since the penetrating depth of the induction current is proportional to the inherent resistance of the carbon substrate used for the susceptor, the electric current flows uniformly within the susceptor, and fewer cracks are generated in the SiC coating formed on the surface of the susceptor. These advantages derive at least in part from the use of a specific electric resistance of 1600 - 5500 μΩ cm as compared with about 1000 μΩcm in the prior art.

Since the specific electric resistance of the susceptor is higher, the electric power consumed in the formation of the susceptor increases. However, the heating efficiency can be improved, by which better workability can be attained, since there is no uneven heat generation in the longitudinal direction of the susceptor, even if the distance between the susceptor and the induction coils is somewhat varied.

As previously noted, in the present invention the SiC coating is thicker than 10 μm. It is impossible to prevent impurities contained in the carbon substrate of the susceptor from being heated and dispersed in the semiconductor wafer, if the thickness is less than 10 μm. Further, if the specific resistance of the carbon substrate is less than 1600 μΩcm, localized heating will occur due to the surface skin effect of the eddy current so as to cause cracks in the SiC coating. If it is larger than 5500 μΩcm, the thermal shock resistance of the carbon substance is reduced and cracks are generated in the carbon substrate upon temperature rising in the susceptor.

BRIEF DESCRIPTION OF THE DRAWING

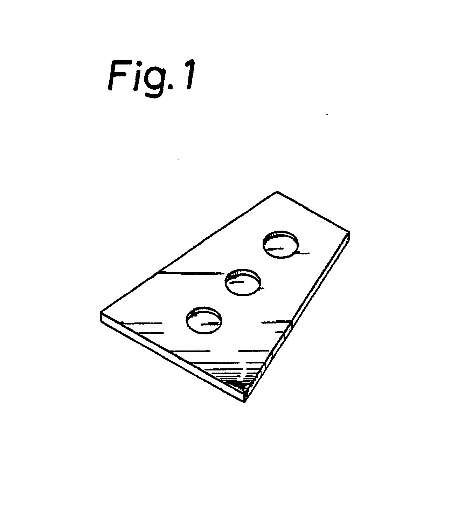

Fig. 1 is a perspective view showing a barrel type susceptor produced according to this invention.

EXAMPLES

Six (6) susceptor substrates, each having a 700 mm outer diameter, a 100 mm inner diameter and a thickness of 15 mm, were prepared by mixing carbon black and coke, with the addition of a binder, and molding, followed by sintering and graphitization. The blending ratio between coke and carbon black was varied to provide the substrates with different specific electric resistances as shown in Table-1.

**Table 1**

| Item Specimen | Specific electric resistance ($\mu\Omega$ cm) | Coke (%) | Carbon black (%) |
|---|---|---|---|
| 1 | 1030 | 100 | 0 |
| 2 | 1480 | 95 | 5 |
| 3 | 1650 | 80 | 20 |
| 4 | 3010 | 70 | 30 |
| 5 | 5500 | 60 | 40 |
| 6 | 6020 | 40 | 60 |

Dense SiC coatings were formed with a thickness of 10 $\mu$m or more on the 6 different substrates described above. They were subjected to heating at a frequency of 35 KHz and 150 KW for 30 minutes in a vertical type epitaxial device having spirally wound induction coils of 20 mm x 20 mm in cross sectional size, followed by spontaneous cooling to room temperature.

Table-2 shows the highest temperature per unit area at any point on the mounting surface of a 50 mm wafer from the outer circumference to the center of the susceptor, with the distance between the induction coils and the susceptor being 40 mm. The results of repeated heating cycles are reported in the remarks.

**Table 2**

| Item Specimen | Tempera-ture (°C) | Remarks |
|---|---|---|
| 1 | 928 | no cracks after 1000 cycles |
| 2 | 1073 | no cracks after 1000 cycles |
| 3 | 1132 | no cracks after 1000 cycles |
| 4 | 1147 | no cracks after 1000 cycles |
| 5 | 1186 | no cracks after 1000 cycles |
| 6 | 1224 | cracks generated in the substrate at the 8th heating cycle |

Since the susceptor for the specimen No. 6 contained a large amount of carbon black blended in and had a high specific electric resistance (6020 $\mu\Omega$cm), it had poor thermal shock resistance and had a short life in cycle use.

Further, while the highest temperature could be increased with ease by bringing the susceptors of the specimen Nos. 1 and 2 closer to the induction coils, temperature scattering at the surface of the susceptors was thereby increased due to the interference of the magnetic field from the coil, the susceptors became more vulnerable to the heat shocks due to the temperature difference and the number of useful cycles was further shortened.

Fig. 1 shows a barrel type susceptor produced according to this invention although the configuration of this susceptor is conventional.

According to this invention, since a carbon substrate having the specific electric resistance of from 1600 to 5500 $\mu\Omega$cm is used and pore-less SiC coating with a thickness of 10 $\mu$m or more is formed on a surface of the carbon substrate, temperature scattering at the surface of the susceptor is eliminated and the susceptor is highly resistant to thermal shocks and free from the effect of thermal shocks due to the temperature difference.

The invention may be embodied in other specific forms without departing from its essential characteristics. The foregoing embodiments are, therefore, to be considered in all respects as illustrative and not restrictive.

**Claims**

1. A susceptor comprising a carbon substrate and a dense SiC coating formed on said carbon substrate, said dense SiC coating having a thickness of at least 10 $\mu$m and said carbon substrate having a specific electric resistance of from 1600 to 5500 $\mu\Omega$cm.

2. A susceptor as defined in Claim 1, wherein the dense SiC coating has no pores.

3. A susceptor as defined in Claim I, wherein the carbon substrate is formed by mixing carbon black and coke with a binder, shaping the mixture, sintering and graphitizing.

4. A susceptor as defined in Claim 3, wherein the carbon black is from about 20 % to 40% and the coke from about 60% to 80%.

## Patentansprüche

1. Suszeptor bestehend aus einem Kohlenstoffsubstrat und einem auf dem Kohlenstoffsubstrat gebildeten dichten SiC-Überzug, wobei der dichte SiC-Überzug eine Dicke von mindestens 10 μm besitzt und das Kohlenstoffsubstrat einen spezifischen elektrischen Widerstand von 1.600–5.500 μΩcm besitzt.

2. Suszeptor nach Anspruch 1, wobei der dichte SiC-Überzug keine Poren hat.

3. Suszeptor nach Anspruch 1, wobei das Kohlenstoffsubstrat durch Mischen von Ruß und Koks mit einem Binder, Formen der Mischung, Sintern und Graphitglühen gebildet ist.

4. Suszeptor nach Anspruch 3, wobei der Rußanteil ungefähr 20% bis 40% und der Koksanteil ungefähr von 60% bis 80% beträgt.

## Revendications

1. Suscepteur comprenant un substrat en carbone et un revêtement en SiC dense formé sur ledit substrat en carbone, ledit revêtement en SiC dense possédant une épaisseur égale à au moins 10 μm et ledit substrat en carbone possédant une résistance électrique spécifique comprise entre 1600 et 5500 μΩ.cm.

2. Suscepteur selon la revendication 1, dans lequel le revêtement en SiC dense ne comporte aucun pore.

3. Suscepteur selon la revendication 1, dans lequel le substrat en carbone est formé par mélange de noir de carbone et de coke avec un liant, mise en forme du mélange, frittage et graphitisation.

4. Suscepteur selon la revendication 3, dans lequel il est prévu entre environ 20% et 40% de noir de carbone et entre environ 60% et 80% de coke.

## Fig. 1